# FASCICULE DE BREVET EUROPEEN

(11) **EP 0 575 229 B1**
(45) Date de publication et mention de la délivrance du brevet: **19.11.1997**
(21) Numéro de dépôt: 93401499.4
(22) Date de dépôt: 11.06.1993
(51) Int. Cl.: G06F 13/42

(54) **Procédé pour partager une mémoire à accès direct entre deux processeurs asynchrones et circuit électronique pour la mise en oeuvre de ce procédé**
Verfahren und Schaltung zur Verteilung eines Speichers mit direktem Zugriff zwischen zwei asynchronen Prozessoren
Method and circuit to share direct access memory between two asynchronous processors

(30) Priorité: 19.06.1992 FR 9207507
(43) Date de publication de la demande: 22.12.1993
(73) Titulaire: SGS-THOMSON MICROELECTRONICS S.A., 94250 Gentilly (FR)
(72) Inventeur: Picco, André, F-38220 Vizille (FR); Menut, Patrick, F-38130 Echirolles (FR)
(74) Mandataire: Schmit, Christian Norbert Marie

(56) Documents cités:
- WO-A-86/04434
- GB-A- 2 053 537

## Description

La présente invention telle qu'elle est définie dans les revendications concerne un procédé pour partager une mémoire à accès direct (RAM) entre deux processeurs asynchrones. L'invention vise également un circuit électronique pour la mise en oeuvre de ce procédé.

On connaît deux méthodes générales pour partager une mémoire entre deux processeurs. La première est l'utilisation d'une "boîte à lettres" commune aux deux processeurs, gérée par un protocole logiciel spécial. Cette méthode est relativement lente et complexe. La seconde méthode est l'utilisation d'une mémoire à double accès (dual port RAM). Une telle mémoire implique une duplication des éléments de commutation permettant la lecture ou l'écriture dans chaque cellule élémentaire de mémoire, une duplication de la logique de décodage des adresses et une logique de gestion des conflits d'écriture entre les deux processeurs. Cette seconde méthode à l'avantage d'être rapide mais sa mise en oeuvre est coûteuse à cause du nombre important de composants élémentaires de la mémoire à double accès.

Le document GB-A-2 053 537 décrit un circuit d'interface d'accès à une mémoire à accès partagé entre deux processeurs. Dans cette interface, on privilégie un accès constant du premier processeur à la mémoire. Le deuxième processeur doit effectuer une requête pour avoir accès à la mémoire.

Le but de la présente invention est d'améliorer ces techniques d'échange de données entre deux processeurs asynchrones en proposant un procédé permettant un accès rapide à la mémoire depuis l'un ou l'autre des processeurs, sans nécessiter un nombre très important de composants supplémentaires.

L'invention propose ainsi un procédé pour partager une mémoire à accès direct entre des premier et deuxième processeurs asynchrones, chacun de ces processeurs étant respectivement relié à la mémoire par l'intermédiaire d'un bus de données, d'un bus d'adresses, d'une ligne de commande de lecture et d'une ligne de commande d'écriture, caractérisé en ce que l'accès à la mémoire est cadencé par un unique signal d'horloge, en ce qu'on génère, en sortie d'un diviseur de fréquence recevant le dit signal d'horloge, un signal de sélection à deux états ayant une fréquence égale à la moitié de la fréquence dudit signal d'horloge, en ce qu'on autorise l'accès du premier processeur à la mémoire lorsque le signal de sélection est à un premier état, et en ce qu'on autorise l'accès du deuxième processeur à la mémoire lorsque le signal de sélection est à un deuxième état.

On réalise ainsi un multiplexage temporel entre les deux processeurs : l'accès à la mémoire est donné alternativement aux deux processeurs à une cadence imposée par l'horloge du premier. Il n'est pas nécessaire de dédoubler les transistors d'accès aux cellules élémentaires de mémoire ni le décodeur d'adresses de la mémoire. En outre, les conflits d'écriture sont éliminés intrinsèquement par la nature temporelle du multiplexage, ce qui évite de prévoir des protocoles de priorité en cas de conflit.

Le procédé est particulièrement bien adapté au cas où l'un des processeurs est sensiblement plus rapide que l'autre. Ce cas se rencontre notamment lorsque la mémoire doit être partagée entre un processeur de traitement de signal (DSP) relativement rapide (temps de cycle typique 60ns) et un processeur d'usage général, ou microprocesseur, relativement lent (temps de cycle typique 200ns). On utilise alors le signal d'horloge du processeur le plus rapide pour cadencer l'accès à la mémoire. Dans ces conditions, le processeur le plus rapide accède à la mémoire en deux cycles afin de toujours présenter adresses, données et signaux de commande en phase avec le cycle qui lui est attribué. Le temps d'accès minimal du processeur le plus lent est également deux fois le temps de cycle du processeur le plus rapide. Si le temps de cycle du processeur le plus lent est au moins deux fois plus long que celui du processeur le plus rapide, l'accès à la mémoire ne ralentit jamais le processeur le plus lent.

Avec le procédé selon l'invention, on peut utiliser comme coeur de la mémoire un plan mémoire tout à fait classique sans spécificité particulière. La logique de contrôle associée est également très simple : il s'agit principalement d'un multiplexage. En outre, l'accès à la mémoire est transparent vis-à-vis de l'extérieur : aucun protocole spécial n'est à respecter.

Le second aspect de l'invention vise un circuit électronique comportant une mémoire à accès direct et pouvant être relié à des premier et deuxième processeurs asynchrones par l'intermédiaire, respectivement, de deux bus de données, de deux bus d'adresses, de deux lignes de commande de lecture et de deux lignes de commande d'écriture, caractérisé en ce que ce circuit électronique est agencé pour recevoir un signal d'horloge, de préférence issu du premier processeur, et cadencer l'accès à la mémoire par ce seul signal d'horloge, et en ce qu'il comprend en outre des moyens de gestion d'accès comprenant un diviseur de fréquence pour produire un signal de sélection à deux états ayant une fréquence égale à la moitié de la fréquence dudit signal d'horloge, l'accès du premier processeur à la mémoire étant autorisé lorsque le signal de sélection est à un premier état, et l'accès du deuxième processeur à la mémoire étant autorisé lorsque le signal de sélection est à un deuxième état. Ce circuit est conçu pour la mise en oeuvre du procédé ci-dessus.

D'autres particularités et avantages de l'invention apparaîtront dans la description ci-après d'un exemple de réalisation préféré et non limitatif, lue conjointement aux dessins annexés, dans lesquels :
- la figure 1 est un schéma synoptique d'un circuit électronique selon l'invention ;
- les figures 2 et 3 sont des chronogrammes illustrant le fonctionnement du circuit de la figure 1 ; et
- la figure 4 est un schéma de moyens logiques de gestion d'accès inclus dans le circuit de la figure 1.

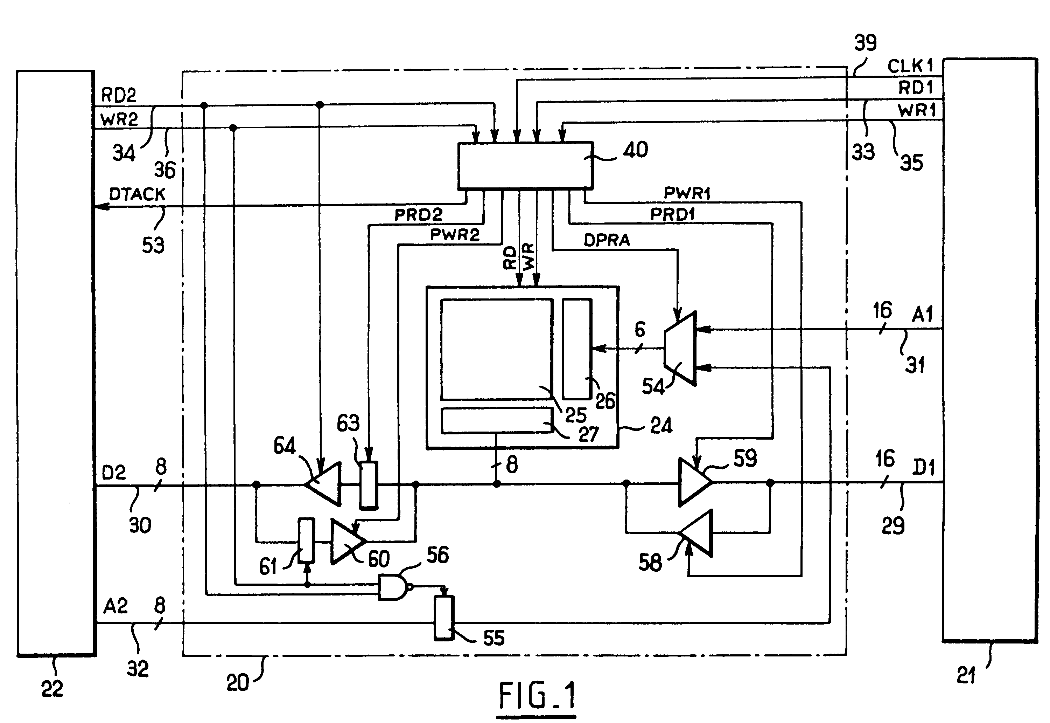

La figure 1 montre un circuit 20 selon l'invention monté entre deux processeurs 21, 22. Le processeur 21 est un processeur de traitement de signal (DSP) fonctionnant sur 16 bits et ayant un temps de cycle relativement court (par exemple 60ns), et le processeur 22 est un microprocesseur d'usage général fonctionnant sur 8 bits et ayant un temps de cycle relativement long (par exemple 200ns) . Les deux processeurs sont réalisés dans deux puces à circuit intégré distinctes. Le circuit 20 est de préférence inclus dans la puce du processeur de traitement de signal 21.

Le circuit électronique 20 comprend une mémoire à accès direct (RAM) 24 comportant de façon classique un groupement de cellules élémentaires de mémoire 25, un décodeur d'adresses 26 pour sélectionner les cellules où un accès est requis, et une interface de données 27 pour échanger des données entre les cellules du groupement 25 et l'extérieur. Dans l'exemple représenté, le groupement 25 est un groupement 64 x 8 bits, c'est-à-dire nécessitant 6 bits d'adresse et 8 bits de donnée pour chaque donnée écrite ou lue dans la mémoire.

Chacun des processeurs 21, 22 est relié au circuit 20 et à la mémoire 24 par l'intermédiaire d'un bus de données bidirectionnel 29, 30, d'un bus d'adresses 31, 32, d'une ligne de commande de lecture 33, 34 et d'une ligne de commande d'écriture 35, 36. Dans l'exemple représenté, les bus de données et d'adresses du processeur de traitement de signal 21 sont des bus à 16 bits, tandis que ceux du microprocesseur 22 sont des bus à 8 bits. Les lignes de commande 33, 34, 35, 36 véhiculent des signaux de commande de lecture ou d'écriture RD1, RD2, WR1, WR2 qui sont issus des processeurs 21, 22 et actifs à l'état logique 0 et inactifs à l'état logique 1.

Le processeur de traitement de signal 21 est en outre relié au circuit 20 par une ligne d'horloge 39 sur laquelle il délivre son signal d'horloge CLK1 qu'on utilise selon l'invention pour cadencer l'accès à la mémoire 24, ce signal d'horloge CLK1 servant par ailleurs à cadencer le fonctionnement du processeur de traitement de signal 21.

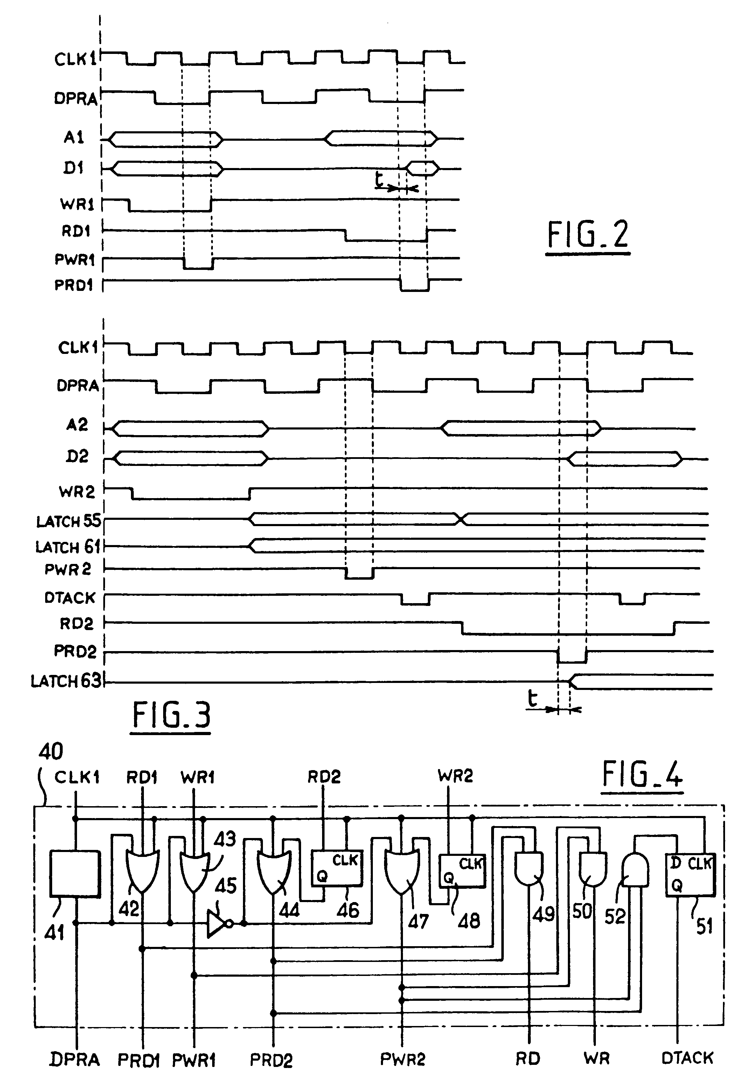

Le circuit 20 comprend une logique de gestion d'accès 40 reliée à la ligne d'horloge 39 et aux lignes de commande de lecture et d'écriture 33, 34, 35, 36 des deux processeurs. La logique de gestion d'accès est agencée pour délivrer les signaux suivants :
- un signal de sélection à deux états DPRA ayant une fréquence égale à la moitié de celle du signal d'horloge CLK1 (voir les deux premières lignes des chronogrammes des figures 2 et 3) ;
- une impulsion de lecture PRD1 de niveau logique 0 émise lorsque le signal de commande de lecture RD1 est actif sur la ligne de commande de lecture 33 du processeur 21 (RD1 = 0) et lorsque les signaux de sélection DPRA et d'horloge CLK1 sont à l'état 0 (figure 2) ;
- une impulsion d'écriture PWR1 de niveau logique 0 émise lorsque le signal de commande d'écriture WR1 est actif sur la ligne de commande d'écriture 35 du processeur 21 (WR1 = 0) et lorsque les signaux de sélection DPRA et d'horloge CLK1 sont à l'état 0 (figure 2) ;
- une impulsion de lecture PRD2 de niveau logique 0 émise après le début de l'activation du signal de commande de lecture RD2 sur la ligne de commande de lecture 34 du microprocesseur 22 (front descendant de RD2), lorsque le signal de sélection DPRA est à l'état 1 et le signal d'horloge CLK1 à l'état 0 (figure 3) ;
- une impulsion d'écriture PWR2 de niveau logique 0 émise après la fin de l'activation du signal de commande d'écriture WR2 sur la ligne de commande d'écriture 36 du microprocesseur 22, lorsque le signal de sélection DPRA est à l'état 1 et le signal d'horloge CLK1 à l'état 0 (figure 3) ;
- une impulsion de lecture RD de niveau logique 0 adressée à la mémoire 24 pour permettre un accès en lecture à la mémoire 24, cette impulsion RD étant produite en même temps qu'une des impulsions de lecture PRD1, PRD2 ;
- une impulsion d'écriture WR de niveau logique 0 adressée à la mémoire 24 pour permettre un accès en écriture à la mémoire 24, cette impulsion WR étant produite en même temps qu'une des impulsions d'écriture PWR1, PWR2 ; et
- une impulsion d'acquittement DTACK de niveau logique 0 émise avec un retard égal à une période du signal d'horloge CLK1 après chaque impulsion de lecture PRD2 et après chaque impulsion d'écriture PWR2 (figure 3).

Un exemple de logique de gestion d'accès 40 pouvant délivrer de tels signaux est illustré à la figure 4. Le signal de sélection DPRA est produit en sortie d'un diviseur de fréquence 41 recevant le signal d'horloge CLK1. L'impulsion de lecture PRD1 est produite en sortie d'une porte OU 42 à trois entrées recevant respectivement les signaux DPRA, RD1 et CLK1. L'impulsion d'écriture PWR1 est produite en sortie d'une porte OU 43 à trois entrées recevant respectivement les signaux DPRA, WR1 et CLK1. L'impulsion de lecture PRD2 est produite en sortie d'une porte OU 44 à trois entrées recevant respectivement l'inverse du signal DPRA (obtenu par l'inverseur 45), le signal CLK1 et une impulsion de niveau logique 0 et de durée égale à deux périodes du signal d'horloge CLK1 délivrée par une bascule 46 en réponse à un front descendant du signal RD2. L'impulsion d'écriture PWR2 est produite en sortie d'une porte OU 47 à trois entrées recevant respectivement l'inverse du signal DPRA, le signal CLK1 et une impulsion de niveau logique 0 et de durée égale à deux périodes du signal d'horloge CLK1 délivrée par une bascule 48 en réponse à un front montant du signal WR2. L'impulsion de lecture RD est produite en sortie d'une porte ET 49 à deux entrées recevant respectivement les signaux impulsionnels PRD1 et PRD2. L'impulsion d'écriture WR est produite en sortie d'une porte ET 50 à deux entrées recevant respectivement les signaux impulsionnels PWR1 et PWR2. L'impulsion d'acquittement DTACK est produite en sortie d'une bascule à retard de type D 51 pilotée par le signal d'horloge CLK1, dont l'entrée est reliée à la sortie d'une porte ET 52 à deux entrées recevant respectivement les signaux impulsionnels PRD2 et PWR2.

Le signal impulsionnel d'acquittement DTACK est adressé au microprocesseur 22 par une ligne d'acquittement 53 (figure 1).

Le circuit 20 comprend en outre un multiplexeur d'adresses 54 commandé par le signal de sélection DPRA. Le multiplexeur 54 a une entrée à 16 bits reliée au bus d'adresses 31 du processeur de traitement de signal 21 et une entrée à 8 bits reliée au bus d'adresses 32 du microprocesseur 22 par l'intermédiaire d'un registre à verrouillage d'adresses 55. La sortie à 6 bits du multiplexeur 54 est reliée au décodeur d'adresses 26 de la mémoire 24. Lorsque le signal de sélection DPRA est à l'état 0, le multiplexeur 54 transmet au décodeur 26 les six bits significatifs de l'adresse A1 présentée sur le bus d'adresse 31 du processeur 21. Lorsque le signal de sélection DPRA est à l'état 1, le multiplexeur 54 transmet au décodeur 26 les six bits significatifs de l'adresse A2 présente dans le registre à verrouillage 55.

Ainsi, le signal de sélection DPRA autorise l'accès du processeur de traitement de signal 21 à la mémoire 24 lorsqu'il est à l'état 0, et l'accès du microprocesseur 22 à la mémoire 24 lorsqu'il est à l'état 1.

Les adresses A2 présentées sur le bus 32 du microprocesseur 22 sont verrouillées dans le registre 55 à la fin de l'activation du signal de commande d'écriture WR2. A cette fin, l'entrée de commande de verrouillage du registre 55 est reliée à la ligne de commande d'écriture 36 du microprocesseur 22. Cette liaison se fait par l'intermédiaire d'une porte NON ET 56 dont une seconde entrée est reliée à la ligne de commande de lecture 34 du microprocesseur 22 afin d'éviter qu'une adresse d'écriture ancienne reste verrouillée dans le registre 55 lors d'une commande de lecture. Le registre 55 est passant lorsqu'il reçoit un signal de niveau 0 de la porte 56 et verrouille l'adresse A2 qu'il contient au moment du front montant du signal issu de la porte 56.

Les impulsions d'écriture PWR1 sont adressées à un tampon d'écriture 58 monté entre le bus de données 29 du processeur de traitement de signal 21 et l'interface de données 27 de la mémoire 24. Le tampon 58 est mis en basse impédance lors d'une impulsion PWR1 de niveau 0 pour écrire dans la mémoire 24 une donnée de 8 bits correspondant aux 8 bits significatifs de la donnée de 16 bits présentée sur le bus 29.

Une telle séquence d'écriture depuis le processeur 21 est illustrée à la partie gauche de la figure 2. Le processeur 21 active son signal d'écriture WR1 à 0 pendant une durée supérieure à un cycle de son signal d'horloge CLK1, pendant qu'il présente une donnée D1 et une adresse A1 sur les bus 29, 31. Lorsque le signal de sélection DPRA devient égal à 0, la logique de gestion d'accès 40 délivre une impulsion d'écriture PWR1 en même temps qu'une impulsion d'écriture WR adressée à la mémoire 24. Pendant ces deux impulsions PWR1, WR, la donnée D1 est écrite à l'adresse spécifiée par le multiplexeur 54 à partir de l'adresse A1 présentée sur le bus 31.

Les impulsions de lecture PRD1 sont adressées à un tampon de lecture 59 monté entre l'interface de données 27 de la mémoire 24 et le bus de données 29 du processeur de traitement de signal 21. Le tampon 59 est mis en basse impédance lors d'une impulsion PRD1 de niveau 0 pour transmettre une donnée lue dans la mémoire 24 sur le bus de données 29 (cette donnée de 8 bits peut être complétée par 8 bits arbitraires sur le bus 29 à 16 bits).

Une telle séquence de lecture depuis le processeur 21 est illustrée à la partie droite de la figure 2. Le processeur 21 active son signal de lecture RD1 à 0 pendant une durée supérieure à un cycle de son signal d'horloge CLK1, pendant qu'il présente une adresse A1 sur le bus 31. Lorsque le signal de sélection DPRA devient égal à 0, la logique de gestion d'accès 40 délivre une impulsion de lecture PRD1 en même temps qu'une impulsion de lecture RD adressée à la mémoire 24. Pendant ces deux impulsions PRD1, RD, la donnée D1 est lue dans la mémoire 24 à l'adresse spécifiée par le multiplexeur 54 à partir de l'adresse A1 présentée sur le bus 31 ; puis cette donnée D1 parvient sur le bus de données 29 du processeur 21 après un temps t égal au temps d'accès à la mémoire 24.

Les impulsions d'écriture PWR2 sont adressées à un tampon d'écriture 60 dont la sortie est reliée à l'interface de données 27 de la mémoire 24 et dont l'entrée est reliée à un registre à verrouillage de données d'écriture 61 relié au bus de données 30 du microprocesseur 22. Le tampon 60 est mis en basse impédance lors d'une impulsion PWR2 de niveau 0 pour écrire dans la mémoire 24 la donnée de 8 bits présente dans le registre 61. L'entrée de commande de verrouillage du registre 61 est reliée à la ligne de commande d'écriture 36 du microprocesseur 22. Le registre 61 est passant lorsqu'il reçoit un signal WR2 de niveau 0 et verrouille la donnée D2 qu'il contient au moment du front montant du signal WR2. Ainsi, les données D2 présentées sur le bus 30 du microprocesseur 22 sont verrouillées dans le registre 61 à la fin de l'activation du signal de commande d'écriture WR2 issu du microprocesseur 22.

Une séquence d'écriture dans la mémoire 24 depuis le microprocesseur 22 est illustrée à la partie gauche de la figure 3. Le microprocesseur 22 active son signal de commande d'écriture WR2 (WR2 = 0) pendant qu'il présente une donnée D2 et une adresse A2 sur les bus 30, 32. A la fin de l'activation du signal de commande d'écriture WR2 (front montant de WR2), la donnée D2 est verrouillée dans le registre 61 et l'adresse A2 est verrouillée dans le registre 55, comme l'indiquent les lignes LATCH 61 et LATCH 55 de la figure 3. Lorsque le signal de sélection DPRA devient égal à 1, la logique de gestion d'accès 40 délivre une impulsion d'écriture PWR2 en même temps qu'une impulsion d'écriture WR adressée à la mémoire 24. Pendant ces deux impulsions PWR2, WR, la donnée D2 verrouillée dans le registre 61 est transmise et écrite dans la mémoire 24 à l'adresse spécifiée par le multiplexeur 54 à partir de l'adresse A2 verrouillée dans le registre 55. Ceci assure que la donnée écrite depuis le microprocesseur 22 est toujours celle présente sur le bus de données 30 au moment du front montant du signal de commande d'écriture WR2. Après que la donnée D2 a effectivement été écrite, la logique de gestion d'accès délivre une impulsion d'acquittement DTACK qui est communiquée au microprocesseur 22 par la ligne d'acquittement 53 pour lui indiquer que la mémoire 24 est disponible pour un nouvel accès.

Les impulsions de lecture PRD2 sont adressées à l'entrée de commande de verrouillage d'un registre à verrouillage de données de lecture 63 relié à l'interface de données 27 de la mémoire 24. Le registre 63 est passant lorsque le signal impulsionnel PRD2 est au niveau 0 et verrouille la donnée qu'il contient au moment du front montant de ce signal PRD2. Ainsi, les données D2 issues de la mémoire 24 sont verrouillées dans le registre 63 à chaque front montant des impulsions de lecture PRD2. La sortie du registre à verrouillage 63 est reliée à l'entrée d'un tampon de lecture 64 dont la sortie est reliée au bus de données 30 du microprocesseur 22. Le tampon 64 est commandé par le signal de commande de lecture RD2 issu du microprocesseur 22 : lorsque RD2 = 0, le tampon 64 est en basse impédance pour faire communiquer le registre à verrouillage 63 avec le bus 30 et transmettre ainsi la donnée présente dans le registre 63 au microprocesseur 22.

Une séquence de lecture dans la mémoire 24 depuis le microprocesseur 22 est illustrée à la partie droite de la figure 3. Le microprocesseur 22 active son signal de commande de lecture RD2 (RD2 = 0) pendant qu'il présente une adresse A2 sur le bus 32. Comme RD2 = 0, la porte NON ET 56 produit un signal à l'état 0 de sorte que le registre 55 est passant et que l'adresse A2 parvient à l'entrée du multiplexeur 54. Lorsque le signal de sélection DPRA devient égal à 1, la logique de gestion d'accès 40 délivre une impulsion de lecture PRD2 en même temps qu'une impulsion de lecture RD adressée à la mémoire 24. Pendant ces deux impulsions, la donnée D2, lue dans la mémoire 24 à l'adresse spécifiée par le multiplexeur 54 à partir de l'adresse A2, apparait dans le registre à verrouillage 63 avec un retard t égal au temps d'accès à la mémoire 24 comme l'indique la ligne LATCH 63 de la figure 3. A la fin de l'impulsion de lecture PRD2 (front montant de PRD2) la donnée D2 est verrouillée dans le registre 63. Après que la donnée D2 a ainsi été verrouillée, la logique de gestion d'accès 40 délivre une impulsion d'acquittement DTACK qui est communiquée au microprocesseur 22 par la ligne d'acquittement 53. Le microprocesseur 22 peut alors maintenir l'activation de son signal de commande de lecture RD2 pendant le temps nécessaire à la réception effective de la donnée lue D2. Il peut ensuite désactiver le signal RD2 à 1 pour libérer son accès à la mémoire 24.

Bien qu'on ait décrit l'invention en référence à un exemple de réalisation préféré, on comprendra que cet exemple n'est pas limitatif et que diverses modifications peuvent lui être apportées sans sortir du cadre de l'invention telle qu'elle est définie dans les revendications.

Ainsi, bien que le signal d'horloge CLK1 ait été décrit comme provenant du processeur de traitement de signal 21, il pourrait également être fourni directement au circuit 20 par une horloge et être transmis du circuit 20 vers le processeur 21, ou encore parvenir en parallèle au circuit 20 et au processeur 21 depuis l'horloge.

## Revendications

1. Procédé pour partager une mémoire à accès direct (24) entre des premier et deuxième processeurs asynchrones (21, 22), chacun de ces processeurs étant respectivement relié à la mémoire (24) par l'intermédiaire d'un bus de données (29, 30), d'un bus d'adresses (31, 32), d'une ligne de commande de lecture (33, 34) et d'une ligne de commande d'écrire (35, 36), caractérisé en ce que l'accès à la mémoire (24) est cadencé par un unique signal d'horloge (CKL1), en ce qu'on génère, en sortie d'un diviseur de fréquence (41), un signal de sélection à deux états (DRPA) ayant une fréquence égale à la moitié de la fréquence dudit signal d'horloge (CLK1), en ce qu'on autorise l'accès du premier processeur (21) à la mémoire (24) lorsque le signal de sélection (DPRA) est à un premier état, et en ce qu'on autorise l'accès du deuxième processeur (22) à la mémoire (24) lorsque le signal de sélection (DPRA) est à un deuxième état.

2. Procédé conforme à la revendication 1, caractérisé en ce que le signal de sélection (DPRA) est utilisé pour commander un multiplexeur d'adresses (54) ayant une entrée reliée au bus d'adresses (31) du premier processeur (21), une entrée reliée au bus d'adresses (32) du deuxième processeur (22), et une sortie reliée à un décodeur d'adresses (26) de la mémoire (24).

3. Procédé conforme à l'une des revendications 1 ou 2, caractérisé en ce qu'on utilise comme signal d'horloge (CLK1) un signal servant par ailleurs à cadencer le fonctionnement du premier processeur (21).

4. Procédé conforme à la revendication 3, caractérisé en ce que, pour écrire une donnée (D2) dans la mémoire (24) depuis le deuxième processeur (22), on effectue les étapes suivantes :
- activation d'un signal de commande d'écriture (WR2) sur la ligne de commande d'écriture (36) du deuxième processeur (22) ;
- présentation de la donnée (D2) sur le bus de données (30) et d'une adresse (A2) sur le bus d'adresses (32) du deuxième processeur (22) ;
- à la fin de l'activation du signal de commande d'écriture (WR2), verrouillage de la donnée (D2) et de l'adresse (A2) dans des registres respectifs (61, 55) ; puis
- production d'une impulsion d'écriture (PWR2) lorsque le signal de sélection (DRPA) est à son deuxième état pour transmettre la donnée verrouillée à l'adresse spécifiée de la mémoire (24).

5. Procédé conforme à la revendication 4, caractérisé en ce qu'on adresse un signal d'acquittement (DTACK) au deuxième processeur (22) après ladite impulsion d'écriture (PWR2).

6. Procédé conforme à l'une des revendications 3 à 5, caractérisé en ce que, pour lire une donnée (D2) dans la mémoire (24) depuis le deuxième processeur (22), on effectue les étapes suivantes :
- activation d'un signal de commande de lecture (RD2) sur la ligne de commande de lecture (34) du deuxième processeur (22) ;
- présentation d'une adresse (A2) sur le bus d'adresses (32) du deuxième processeur (22) ;
- après le début de l'activation du signal de commande de lecture (RD2), production d'une impulsion de lecture (PRD2) lorsque le signal de sélection (DRPA) est à son deuxième état pour lire la donnée (D2) à l'adresse spécifiée dans la mémoire (24) ; et
- à la fin de l'impulsion de lecture (PRD2), verrouillage de la donnée lue dans un registre (63), ce registre communiquant avec le bus de données (30) du second processeur (22) tant que le signal de commande de lecture (RD2) est actif.

7. Procédé conforme à la revendication 6, caractérisé en ce qu'on adresse un signal d'acquittement (DTACK) au deuxième processeur (22) après ladite impulsion de lecture (PRD2).

8. Circuit électronique (20) comportant une mémoire à accès direct (24) et pouvant être relié à des premier et deuxième processeurs asynchrones (21, 22) par l'intermédiaire, respectivement, de deux bus de données (29, 30), de deux bus d'adresses (31, 32), de deux lignes de commande de lecture (33, 34) et de deux lignes de commande d'écriture (35, 36), caractérisé en ce que ce circuit électronique est agencé pour recevoir un signal d'horloge (CLK1) et cadencer l'accès à la mémoire (24) par ce seul signal d'horloge (CLK1), et en ce qu'il comprend en outre des moyens de gestion d'accès (40) comprenant un diviseur de fréquence (41) pour produire un signal de sélection à deux états (DPRA) ayant une fréquence égale à la moitié de la fréquence dudit signal d'horloge (CLK1), l'accès du premier processeur (21) à la mémoire (24) étant autorisé lorsque le signal de sélection (DPRA) est à un premier état, et l'accès du deuxième processeur (22) à la mémoire (24) étant autorisé lorsque le signal de sélection (DPRA) est à un deuxième état.

9. Circuit électronique conforme à la revendication 8, caractérisé en ce que le signal d'horloge (CLK1) est reçu par une ligne d'horloge (39) issue du premier processeur (21).

10. Circuit électronique conforme à la revendication 9, caractérisé en ce qu'il comprend un multiplexeur d'adresses (54) ayant deux entrées respectivement reliées aux deux bus d'adresses (31, 32) et une sortie reliée à un décodeur d'adresses (26) de la mémoire (24), ce multiplexeur d'adresses (54) étant commandé par le signal de sélection (DPRA).

11. Circuit électronique conforme à la revendication 10, caractérisé en ce qu'une entrée du multiplexeur d'adresses est reliée au bus d'adresses (32) du deuxième processeur (22) par l'intermédiaire d'un registre à verrouillage d'adresses (55), le circuit comprenant en outre un registre à verrouillage de données d'écriture (61) ayant une entrée reliée au bus de données (30) du deuxième processeur (22) et une sortie reliée à un tampon d'écriture (60), le verrouillage de ces deux registres (55, 61) étant commandé par la fin de l'activation d'un signal de commande d'écriture (WR2) sur la ligne de commande d'écriture (36) du deuxième processeur (22), le tampon d'écriture (60) étant relié aux moyens de gestion d'accès (40) pour recevoir une impulsion d'écriture (PWR2) générée après la fin de l'activation du signal de commande d'écriture (WR2) sur la ligne de commande d'écriture (36) du deuxième processeur (22) et lorsque le signal de sélection (DRPA) est à son deuxième état, le tampon d'écriture (60) étant agencé pour transmettre une donnée (D2) présente dans le registre à verrouillage de données d'écriture (61) lors de la réception de l'impulsion d'écriture (PWR2).

12. Circuit électronique conforme à l'une des revendications 9 à 11, caractérisé en ce qu'il comprend un registre à verrouillage de données de lecture (63) ayant une entrée reliée à la mémoire (24) et une sortie reliée au bus de données (30) du deuxième processeur (22) par l'intermédiaire d'un tampon de lecture (64), le verrouillage de ce registre (63) étant commandé par la fin d'une impulsion de lecture (PRD2) générée par les moyens de gestion d'accès (40) après le début de l'activation d'un signal de commande de lecture (RD2) sur la ligne de commande de lecture (34) du deuxième processeur (22) lorsque le signal de sélection (DPRA) est à sont deuxième état, le tampon de lecture (64) étant agencé pour transmettre une donnée (D2) présente dans le registre à verrouillage de données de lecture (63) pendant l'activation du signal de commande de lecture (RD2).

13. Circuit électronique conforme à l'une des revendications 9 à 12, caractérisé en ce qu'il est inclus dans une puce à circuit intégré, comportant en outre le premier processeur (21).

## Patentansprüche

1. Verfahren, um einen Speicher mit direktem Zugriff (24) auf einen ersten und einen zweiten asynchronen Prozessor (21, 22) aufzuteilen, wobei jeder der Prozessoren jeweils mit dem Speicher (24) über einen Datenbus (29, 30), einen Adreßbus (31, 32), eine Lesesteuerleitung (33, 34) und eine Schreibsteuerleitung (35, 36) verbunden ist, dadurch gekennzeichnet, daß der Zugriff auf den Speicher (24) durch ein einziges Taktsignal (CLK1) getaktet wird, daß man am Ausgang eines Frequenzteilers (41) ein Auswahlsignal mit zwei Zuständen (DRPA) erzeugt, das eine Frequenz hat, die gleich der Hälfte der Frequenz des besagten Taktsignals (CLK1) ist, daß man den Zugriff des ersten Prozessors (21) auf den Speicher (24) erlaubt, wenn das Auswahlsignal (DPRA) sich in einem ersten Zustand befindet, und daß man den Zugriff des zweiten Prozessors (22) auf den Speicher (24) erlaubt, wenn sich das Auswahlsignal (DPRA) in einem zweiten Zustand befindet.

2. Verfahren nach Anspruch 1, dadurch gekennzeichnet, daß das Auswahlsignal (DPRA) verwendet wird, um einen Adreßmultiplexer (54) zu steuern, der einen Eingang hat, der mit dem Adreßbus (31) des ersten Prozessors (21) verbunden ist, einen Eingang hat, der mit dem Adreßbus (32) des zweiten Prozessors (22) verbunden ist, und einen Ausgang hat, der mit einem Adreßdekoder (26) des Speichers (24) verbunden ist.

3. Verfahren nach einem der Ansprüche 1 oder 2, dadurch gekennzeichnet, daß man als Taktsignal (CLK1) ein Signal verwendet, das im übrigen dazu dient, die Funktion des ersten Prozessors (21) zu takten.

4. Verfahren nach Anspruch 3, dadurch gekennzeichnet, daß zum Schreiben von Daten (D2) im Speicher (24) durch den zweiten Prozessor (22) folgende Schritte durchgeführt werden:
- Aktivieren eines Schreibsteuersignals (WR2) auf der Schreibsteuerleitung (36) des zweiten Prozessors (22);
- Anlegen von Daten (D2) auf dem Datenbus (30) und einer Adresse (A2) auf dem Adreßbus (32) des zweiten Prozessors (22);
- am Ende des Aktivierens des Schreibsteuersignals (WR2) Verriegeln der Daten (D2) und der Adresse (A2) in den jeweiligen Registern (61, 55); dann
- Erzeugen eines Schreibimpulses (PWR2), wenn das Auswahlsignal (DRPA) sich im zweiten Zustand befindet, um die verriegelten Daten an die spezifizierte Adresse im Speicher (24) zu übertragen.

5. Verfahren nach Anspruch 4, dadurch gekennzeichnet, daß man ein Quittierungssignal (DTACK) an den zweiten Prozessor (22) nach dem Schreibimpuls (PWR2) abschickt.

6. Verfahren nach einem der Ansprüche 3 bis 5, dadurch gekennzeichnet, daß zum Lesen von Daten (D2) in dem Speicher (24) durch den zweiten Prozessor (22) die folgenden Schritte ausgeführt werden:
- Aktivieren eines Lesesteuersignals (RD2) auf der Lesesteuerleitung (34) des zweiten Prozessors (22);
- Anlegen einer Adresse (A2) auf dem Adreßbus (32) des zweiten Prozessors (22) ;
- nach dem Starten des Aktivierens des Lesesteuersignals (RD2) Erzeugen eines Leseimpulses (PRD2), wenn sich das Auswahlsignal (DRPA) in seinem zweiten Zustand befindet, um die Daten (D2) an der spezifizierten Adresse in dem Speicher (24) zu lesen; und
- am Ende des Leseimpulses (PRD2) Verriegeln der gelesenen Daten in einem Register (63), wobei dieses Register mit dem Datenbus (30) des zweiten Prozessors (22) kommuniziert, solange das Lesesteuersignal (RD2) aktiv ist.

7. Verfahren nach Anspruch 6, dadurch gekennzeichnet, daß man ein Quittierungssignal (DTACK) an den zweiten Prozessor (22) nach dem Leseimpuls (PRD2) adressiert.

8. Elektronischer Schaltkreis (20) mit einem Speicher für den direkten Zugriff (24) und für die jeweilige Verbindung mit einem ersten und einem zweiten asynchronen Prozessor (21, 22) über zwei Datenbusse (29, 30), zwei Adreßbusse (31, 32), zwei Lesesteuerleitungen (33, 34) und zwei Schreibsteuerleitungen (35, 36), dadurch gekennzeichnet, daß dieser elektronische Schaltkreis dazu dient, ein Taktsignal (CLK1) zu empfangen und den Zugriff auf den Speicher (24) durch ein einziges Taktsignal (CLK1) zu takten, und dadurch daß er außerdem Zugriffsverwaltungsvorrichtungen (40) mit einem Frequenzteiler (41) umfaßt, um ein Auswahlsignal mit zwei Zuständen (DPRA) zu erzeugen, das eine Frequenz hat, die gleich der Hälfte der Frequenz des besagten Taktsignals (CLK1) ist, wobei der Zugriff vom ersten Prozessor (21) auf den Speicher (24) freigegeben wird, wenn sich das Auswahlsignal (DPRA) in einem ersten Zustand befindet, und der Zugriff des zweiten Prozessors (22) auf den Speicher (24) freigegeben wird, wenn sich das Auswahlsignal (DPRA) in einem zweiten Zustand befindet.

9. Elektronischer Schaltkreis nach Anspruch 8, dadurch gekennzeichnet, daß das Taktsignal (CLK1) über eine Taktleitung (39) vom ersten Prozessor (21) empfangen wird.

10. Elektronischer Schaltkreis nach Anspruch 9, dadurch gekennzeichnet, daß er einen Adreßmultiplexer (54) mit zwei Eingängen umfaßt, die jeweils mit den zwei Adreß bussen (31, 32) verbunden sind, und einen Ausgang, der mit einem Adreßdekoder (26) des Speichers (24) verbunden ist, wobei der Adreßmultiplexer (54) durch das Auswahlsignal (DPRA) gesteuert wird.

11. Elektronischer Schaltkreis nach Anspruch 10, dadurch gekennzeichnet, daß ein Eingang des Adressenmultiplexers mit dem Adreßbus (32) des zweiten Prozessors (22) über ein Adressenverriegelungsregister (55) verbunden ist, wobei der Schaltkreis außerdem ein Schreibdatenverriegelungsregister (61) umfaßt, das einen Eingang hat, der mit dem Datenbus (30) des zweiten Prozessors (22) verbunden ist, und einen Ausgang hat, der mit einem Schreibzwischenspeicher (60) verbunden ist, wobei die Verriegelung der zwei Register (55, 61) gesteuert wird durch das Ende der Aktivierung eines Schreibsteuersignals (WR2) auf der Schreibsteuerleitung (36) des zweiten Prozessors (22), wobei der Schreibzwischenspeicher (60) mit den Zugriffsverwaltungsvorrichtungen (40) verbunden ist, um einen Schreibimpuls (PWR2) zu empfangen, der erzeugt wurde nach dem Ende der Aktivierung des Schreibsteuersignals (WR2) auf der Schreibsteuerleitung (36) des zweiten Prozessors (22), und wenn sich das Auswahlsignal (DRPA) in seinem zweiten Zustand befindet, wobei der Schreibzwischenspeicher (60) dazu dient, Daten (D2) zu übertragen, die sich beim Empfang des Schreibimpulses (PWR2) in dem Schreibdatenverriegelungsregister (61) befinden.

12. Elektronischer Schaltkreis nach einem der Ansprüche 9 bis 11, dadurch gekennzeichnet, daß er ein Lesedatenverriegelungsregister (63) umfaßt, dessen einer Eingang mit dem Speicher (24) verbunden ist und dessen einer Ausgang mit dem Datenbus (30) des zweiten Prozessors (22) über einen Lesezwischenspeicher (64) verbunden ist, wobei die Verriegelung dieses Registers (63) durch das Ende eines Leseimpulses (PRD2) gesteuert wird, der erzeugt wird durch Zugriffsverwaltungsvorrichtungen (40) nach Beginn der Aktivierung eines Lesesteuersignals (RD2) auf der Lesesteuerleitung (34) des zweiten Prozessors (22), wenn sich das Auswahlsignal (DPRA) in seinem zweiten Zustand befindet, wobei der Lesezwischenspeicher (64) dazu dient, Daten (D2) zu übertragen, die in dem Lesedatenverriegelungsspeicher (63) während der Aktivierung des Lesesteuersignals (RD2) vorliegen.

13. Elektronischer Schaltkreis nach einem der Ansprüche 9 bis 12, dadurch gekennzeichnet, daß er sich in einem Chip eines integrierten Schaltkreises befindet, der außerdem den ersten Prozessor (21) umfaßt.

## Claims

1. Method for sharing a direct-access memory (24) between first and second asynchronous processors (21, 22), each of these processors being respectively connected to the memory (24) by means of a data bus (29, 30), an address bus (31, 32), a read control line (33, 34) and a write control line (35, 36), characterised in that the access to the memory (24) is timed by a single clock signal (CKL1), in that there is generated, at the output of a frequency divider (41), a two-state selection signal (DRPA) having a frequency equal to one half the frequency of the said clock signal (CLK1), in that access of the first processor (21) to the memory (24) is enabled when the selection signal (DPRA) is at a first state, and in that access of the second processor (22) to the memory (24) is enabled when the selection signal (DPRA) is at a second state.

2. Method according to Claim 1, characterised in that the selection signal (DPRA) is used for controlling an address multiplexer (54) having an input connected to the address bus (31) of the first processor (21), an input connected to the address bus (32) of the second processor (22), and an output connected to an address decoder (26) of the memory (24).

3. Method according to one of Claims 1 or 2, characterised in that there is used as the clock signal (CLK1) a signal also serving to time the operation of the first processor (21).

4. Method according to Claim 3, characterised in that, in order to write a data item (D2) into the memory (24) from the second processor (22), the following steps are performed:
- activation of a write control signal (WR2) on the write control line (36) of the second processor (22);
- presentation of the data item (D2) on the data bus (30) and of an address (A2) on the address bus (32) of the second processor (22) ;
- at the end of the activation of the write control signal (WR2), latching of the data item (D2) and of the address (A2) in respective registers (61, 55); and then
- the production of a write pulse (PWR2) when the selection signal (DRPA) is at its second state in order to transmit the latched data item to the specified address of the memory (24).

5. Method according to Claim 4, characterised in that an acknowledgement signal (DTACK) is addressed to the second processor (22) after the said write pulse (PWR2).

6. Method according to one of Claims 3 to 5, characterised in that, in order to read a data item (D2) into the memory (24) from the second processor (22), the following steps are performed:
- activation of a read control signal (RD2) on the read control line (34) of the second processor (22);
- presentation of an address (A2) on the address bus (32) of the second processor (22) ;
- after the start of the activation of the read control signal (RD2), the production of a read pulse (PRD2) when the selection signal (DRPA) is at its second state in order to read the data item (D2) at the specified address in the memory (24); and
- at the end of the read pulse (PRD2), the latching of the data item read in a register (63), this register communicating with the data bus (30) of the second processor (22) as long as the read control signal (RD2) is active.

7. Method according to Claim 6, characterised in that an acknowledgement signal (DTACK) is addressed to the second processor (22) after the said read pulse (PRD2).

8. Electronic circuit (20) including a direct-access memory (24) and capable of being connected to first and second asynchronous processors (21, 22) by means, respectively, of two data buses (29, 30), two address buses (31, 32), two read control lines (33, 34) and two write control lines (35, 36), characterised in that this electronic circuit is arranged to receive a clock signal (CLK1) and time the access to the memory (24) by this sole clock signal (CLK1), and in that it also comprises access management means (40) comprising a frequency divider (41) for producing a two-state selection signal (DPRA) having a frequency equal to one half the frequency of the said clock signal (CLK1), the access of the first processor (21) to the memory (24) being enabled when the selection signal (DPRA) is at a first state, and the access of the second processor (22) to the memory (24) being enabled when the selection signal (DPRA) is at a second state.

9. Electronic circuit according to Claim 8, characterised in that the clock signal (CLK1) is received by a clock line (39) coming from the first processor (21).

10. Electronic circuit according to Claim 9, characterised in that it comprises an address multiplexer (54) having two inputs respectively connected to the two address buses (31, 32) and an output connected to an address decoder (26) of the memory (24), this address multiplexer (54) being controlled by the selection signal (DPRA).

11. Electronic circuit according to Claim 10, characterised in that an input of the address multiplexer is connected to the address bus (32) of the second processor (22) by means of an address latching register (55), the circuit also comprising a write data latching register (61) having an input connected to the data bus (30) of the second processor (22) and an output connected to a write buffer (60), the latching of these two registers (55, 61) being controlled by the end of the activation of a write control signal (WR2) on the write control line (36) of the second processor (22), the write buffer (60) being connected to the access management means (40) for receiving a write pulse (PWR2) generated after the end of the activation of the write control signal (WR2) on the write control line (36) of the second processor (22) and when the selection signal (DRPA) is at its second state, the write buffer (60) being arranged to transmit a data item (D2) present in the write data latching register (61) when the write pulse (PWR2) is received.

12. Electronic circuit according to one of Claims 9 to 11, characterised in that it comprises a read data latching register (63) having an input connected to the memory (24) and an output connected to the data bus (30) of the second processor (22) by means of a read buffer (64), the latching of this register (63) being controlled by the end of a read pulse (PRD2) generated by the access management means (40) after the start of the activation of a read control signal (RD2) on the read control line (34) of the second processor (22) when the selection signal (DPRA) is at its second state, the read buffer (64) being arranged to transmit a data item (D2) present in the read data latching register (63) during the activation of the read control signal (RD2).

13. Electronic circuit according to one of Claims 9 to 12, characterised in that it is included in an integrated circuit chip, also including the first processor (21).
